# EUROPEAN PATENT APPLICATION

(11) **EP 4 527 841 A1**
(43) Date of publication of application: **26.03.2025**
(21) Application number: 23807413.2
(22) Date of filing: 27.04.2023
(51) Int. Cl.: C07F 7/10, H01L 21/306, H01L 21/308

(54) **METHOD FOR PRODUCING AQUEOUS SOLUTION OF PURIFIED AMINOSILANOL COMPOUND AND AMINOSILOXANE COMPOUND, AND COMPOSITION FOR ETCHING**

(30) Priority: 19.05.2022 JP 2022082415; 30.11.2022 JP 2022191819
(71) Applicant: SHIN-ETSU CHEMICAL CO., LTD., Tokyo 1000005 (JP)
(72) Inventor: HIGASHIMURA, Naoki, Joetsu-shi, Niigata 942-8601 (JP); KIYOMORI, Ayumu, Joetsu-shi, Niigata 942-8601 (JP)
(74) Representative: Mewburn Ellis LLP
(86) International application number: PCT/JP2023/016647
(87) International publication number: WO 2023/223803

(57) **Abstract**

A method that brings an aqueous solution containing an aminosilanol compound represented by general formula (1)

R¹R²N-R³-SiR⁴ₘ(OH)₃₋ₘ (1)

(R¹ and R² represent a hydrogen atom, a C1-20 monovalent hydrocarbon group, etc., R³ represents a C1-20 divalent hydrocarbon group, R⁴ represents a C1-20 monovalent hydrocarbon group, and m represents an integer of 0-2.) and a condensate thereof into contact with an acidic cation exchange resin and produces an aqueous solution of a purified aminosilanol compound and aminosiloxane compound that removes metal components in the aqueous solution, the concentration of aminosilanol compound and aminosiloxane compound in the aqueous solution brought into contact with the acidic cation exchange resin being 10-70 mass%, gives an aqueous solution of a purified aminosilanol compound and aminosiloxane compound in which metal impurities contained therein are efficiently decreased.

## Description

### TECHNICAL FIELD

The present invention relates to a method for producing an aqueous solution of a purified aminosilanol compound and aminosiloxane compound and a composition for etching.

### BACKGROUND ART

Aminosilanol compounds are used as surface treatment agents and water-based coating materials and are also used as additives in etching materials to improve the etching selectivity of nitride films to oxide films and to inhibit formation of particles (Patent Document 1).

### PRIOR ART DOCUMENTS

### PATENT DOCUMENTS

Patent Document 1: JP-A 2018-538692

### SUMMARY OF INVENTION

### TECHNICAL PROBLEM

In semiconductor production processes, it is desirable to reduce metal impurities as much as possible since metal impurities may have a negative effect on electrical characteristics and the shape to be formed. Thus, it can be thought that it is also preferred to reduce metal impurities in an etching step. In general, however, etching is necessarily followed by a cleaning step, and even if an aminosilanol compound and an aminosiloxane compound with reduced metal impurities are not used, it is thought that metal impurities are washed away in the subsequent cleaning step. In this regard, a purified aminosilanol compound is also not used in Patent Document 1 above.

However, metal impurities adhering to the surface of a substrate for semiconductors are difficult to remove in a cleaning step after etching, and directly subjecting the substrate having the surface thereof contaminated to the subsequent steps may result in, for example, pattern defects and poor insulating film withstand voltage.

On the other hand, in Patent Document 1, an aminosilanol compound is added as an additive in an amount of 1.2 wt% to an etching composition. When the aminosilanol compound is added as a solid, it is contemplated to perform purification by crystallization to remove metal impurities contained in the solid and other impurities that may form particles. However, purification by crystallization requires dedicated crystallization equipment and crushing equipment for the crystallized solid, and when crystallization is performed within a short period of time, the impurities are likely to be incorporated into the solid without being completely removed.

When the aminosilanol compound is added as an aqueous solution, purification can be performed by an operation such as filtration and is therefore easier than when the aminosilanol compound is added as a solid. However, when the aminosilanol compound concentration is low, a large amount of aqueous solution is added to achieve the effectiveness of the amine component. As a result, a large amount of water, which is a solvent, dilutes the entire etching material and weakens its acidity, which is required for etching. Thus, it is preferred that the aqueous solution used be used in high concentration.

The present invention has been made in view of the foregoing circumstances, and an object of the present invention is to provide a method for producing an aqueous solution of a purified aminosilanol compound and aminosiloxane compound in which metal impurities contained in the aqueous solution of the aminosilanol compound and the aminosiloxane compound are efficiently reduced, and also to provide a composition for etching.

### SOLUTION TO PROBLEM

The inventors have conducted studies to achieve the foregoing object and have found that metal impurities contained in an aqueous solution of an aminosilanol compound and an aminosiloxane compound can be reduced by contacting the aqueous solution containing the aminosilanol compound and the aminosiloxane compound with an acidic cation exchange resin, which is originally not suitable for purification of basic compounds, by a method such as liquid flow. This finding has led to the completion of the present invention.

That is, the present invention provides:
1. A method for producing an aqueous solution of a purified aminosilanol compound and aminosiloxane compound, the method including contacting, with an acidic cation exchange resin, an aqueous solution containing an aminosilanol compound and an aminosiloxane compound that is a condensate thereof to remove a metal component from the aqueous solution, the aminosilanol compound being represented by the following general formula (1):

   R¹R²N-R³-SiR⁴ₘ(OH)₃₋ₘ (1)

   wherein R¹ and R² each independently represent a hydrogen atom or a substituted or unsubstituted monovalent hydrocarbon group having 1 to 20 carbon atoms that may contain a heteroatom, R¹ and R² may be bonded together to form a ring with a nitrogen atom to which R¹ and R² are bonded, R³ represents a substituted or unsubstituted divalent hydrocarbon group having 1 to 20 carbon atoms that may contain a heteroatom, R⁴ represents a substituted or unsubstituted monovalent hydrocarbon group having 1 to 20 carbon atoms, and m represents an integer of 0 to 2,
   wherein the concentration of the aminosilanol compound and the aminosiloxane compound in the aqueous solution to be contacted with the acidic cation exchange resin is 10 to 70 wt%.
2. The method for producing an aqueous solution of a purified aminosilanol compound and aminosiloxane compound according to 1, wherein the aqueous solution to be contacted with the acidic cation exchange resin further contains a silanol compound represented by the following general formula (2) and a siloxane compound that is a condensate thereof:

   R⁵ₙSi(OH)₄₋ₙ (2)

   wherein R⁵ represents a substituted or unsubstituted monovalent hydrocarbon group having 1 to 20 carbon atoms, and n represents an integer of 0 to 3.
3. A composition for etching containing an aqueous solution of an aminosilanol compound and an aminosiloxane compound, the composition for etching having sodium, potassium, and calcium contents respectively of less than 250 ppb and an iron content of less than 100 ppb.
4. The composition for etching according to 3, wherein the aminosilanol compound and the aminosiloxane compound are an aminosilanol compound represented by the following general formula (1) and an aminosiloxane compound that is a condensate thereof:

   R¹R²N-R³-SiR⁴ₘ(OH)₃₋ₘ (1)

   wherein R¹ and R² each independently represent a hydrogen atom or a substituted or unsubstituted monovalent hydrocarbon group having 1 to 20 carbon atoms that may contain a heteroatom, R¹ and R² may be bonded together to form a ring with a nitrogen atom to which R¹ and R² are bonded, R³ represents a substituted or unsubstituted divalent hydrocarbon group having 1 to 20 carbon atoms that may contain a heteroatom, R⁴ represents a substituted or unsubstituted monovalent hydrocarbon group having 1 to 20 carbon atoms, and m represents an integer of 0 to 2.
5. The composition for etching according to 3 or 4, wherein the aqueous solution further contains a silanol compound represented by the following general formula (2) and a siloxane compound that is a condensate thereof:

   R⁵ₙSi(OH)₄₋ₙ (2)

   wherein R⁵ represents a substituted or unsubstituted monovalent hydrocarbon group having 1 to 20 carbon atoms, and n represents an integer of 0 to 3.

### ADVANTAGEOUS EFFECTS OF INVENTION

According to the present invention, an aqueous solution of a purified aminosilanol compound and aminosiloxane compound with reduced metal impurities is obtained.

This aqueous solution with reduced metal impurity contents is suitable for a composition for etching, and a composition for etching that contains this aqueous solution can be used for etching to reduce the frequency of occurrence of, for example, short circuits and disconnections in patterns.

### DESCRIPTION OF EMBODIMENTS

The present invention will be specifically described below.

A method for producing an aqueous solution of a purified aminosilanol compound and aminosiloxane compound according to the present invention uses an acidic cation exchange resin to purify an aqueous solution of an aminosilanol compound represented by the following general formula (1) and an aminosiloxane compound that is a condensate thereof:

R¹R²N-R³-SiR⁴ₘ(OH)₃₋ₘ (1)

In the general formula (1), R¹ and R² each independently represent a hydrogen atom or a substituted or unsubstituted monovalent hydrocarbon group having 1 to 20 carbon atoms, preferably 1 to 10 carbon atoms, more preferably 1 to 8 carbon atoms, that may contain a heteroatom.

The monovalent hydrocarbon group for R¹ and R² may be linear, branched, or cyclic, and specific examples thereof include linear alkyl groups such as methyl, ethyl, n-propyl, n-butyl, n-pentyl, n-hexyl, n-heptyl, n-octyl, n-nonyl, decyl, dodecyl, tetradecyl, hexadecyl, octadecyl, and icosyl groups; branched alkyl groups such as isopropyl, isobutyl, sec-butyl, tert-butyl, thexyl, and 2-ethylhexyl groups; cyclic alkyl groups such as cyclopentyl and cyclohexyl groups; alkenyl groups such as vinyl, allyl, and 1-propenyl groups; aryl groups such as phenyl and tolyl groups; and aralkyl groups such as a benzyl group. Of these, a methyl group, an ethyl group, and an n-propyl group are more preferred.

The monovalent hydrocarbon group may contain a heteroatom selected from an oxygen atom, a nitrogen atom, a sulfur atom, and a silicon atom. Specific examples of such monovalent hydrocarbon groups include hydroxyethyl, methoxyethyl, ethoxyethyl, ethoxypropyl, glycidyl, aminomethyl, aminoethyl, mercaptomethyl, mercaptoethyl, trimethylsilyl, carboxymethyl, methylamidomethyl, methyl ethanoate, and methyl propionate groups. In particular, a hydroxyethyl group, an aminoethyl group, and a methyl ethanoate group are preferred.

In addition, the monovalent hydrocarbon group may have some or all of the hydrogen atoms of the hydrocarbon group replaced by other substituents. Specific examples of other substituents include alkoxy groups having 1 to 5 carbon atoms, such as methoxy, ethoxy, and (iso)propoxy groups; halogen atoms such as a fluorine atom, a chlorine atom, a bromine atom, and an iodine atom; a cyano group; an amino group; acyl groups having 2 to 10 carbon atoms; and trialkylsilyl groups in which the alkyl group has 1 to 5 carbon atoms. In particular, a methoxy group, an ethoxy group, and a trialkylsilyl group are preferred.

In addition, specific examples of rings having 2 to 20 carbon atoms that are formed by R¹ and R² bonded together with a nitrogen atom to which R¹ and R² are bonded include a pyrrolidine ring, a piperidine ring, a piperazine ring, and a morpholine ring.

R³ is a hydrogen atom or a substituted or unsubstituted divalent hydrocarbon group having 1 to 20 carbon atoms, preferably 1 to 10 carbon atoms, more preferably 1 to 8 carbon atoms, that may contain a heteroatom.

The divalent hydrocarbon group for R³ may be linear, branched, or cyclic, and specific examples thereof include linear alkylene groups such as methylene, ethylene, trimethylene, tetramethylene, pentamethylene, hexamethylene, heptamethylene, octamethylene, nonamethylene, decylene, dodecylene, tetradecylene, hexadecylene, octadecylene, and icosylene groups; branched alkylene groups such as propylene, isobutylene, sec-butylene, and tert-butylene groups; cyclic alkylene groups such as cyclopropylene, cyclobutylene, cyclopentylene, and cyclohexylene groups; alkenylene groups such as ethenylene, propenylene, butenylene, pentenylene, hexenylene, heptenylene, octenylene, decenylene, dodecenylene, tetradecenylene, hexadecenylene, octadecenylene, and icosenylene groups; arylene groups such as phenylene and naphthylene groups; and aralkylene groups such as methylenephenylene and methylenephenylenemethylene groups. **In** particular, a methylene group, an ethylene group, and a trimethylene group are more preferred.

The divalent hydrocarbon group may contain a heteroatom selected from an oxygen atom, a nitrogen atom, a sulfur atom, and a silicon atom. Specific examples of such divalent hydrocarbon groups include methyleneoxymethylene, methyleneoxyethylene, methyleneoxytrimethylene, ethyleneoxymethylene, ethyleneoxyethylene, ethyleneoxytrimethylene, propyleneoxymethylene, trimethyleneoxyethylene, propyleneoxytrimethylene, methyleneaminomethylene, methyleneaminoethylene, methyleneaminotrimethylene, ethyleneaminomethylene, ethyleneaminoethylene, ethyleneaminotrimethylene, trimethyleneaminomethylene, trimethyleneaminoethylene, trimethyleneaminotrimethylene, methylenethiomethylene, methylenethioethylene, methylenethiotrimethylene, ethylenethiomethylene, ethylenethioethylene, ethylenethiotrimethylene, trimethylenethiomethylene, trimethylenethioethylene, trimethylenethiopropylene, methylenedimethylsilamethylene, ethylenedimethylsilaethylene, and ethylenedimethylsilatrimethylene groups. **In** particular, an ethyleneaminoethylene group, an ethyleneaminotrimethylene group, a trimethyleneaminoethylene group, and a trimethyleneaminotrimethylene group are preferred.

**In** addition, the divalent hydrocarbon group may have some or all of the hydrogen atoms of the hydrocarbon group replaced by other substituents. Specific examples of other substituents include those similar to the substituents given as examples for R¹ and R².

R⁴ is a substituted or unsubstituted monovalent hydrocarbon group having 1 to 20 carbon atoms, preferably 1 to 10 carbon atoms, more preferably 1 to 8 carbon atoms.

The monovalent hydrocarbon group for R⁴ may be linear, branched, or cyclic, and specific examples thereof include those similar to the substituents given as examples for R¹ and R².
m is an integer of 0 to 2, namely, 0, 1, or 2.

Specific examples of aminosilanol compounds represented by the general formula (1) include aminomethylsilanetriol, aminomethylmethylsilanediol, aminomethyldimethylsilanol, aminoethylsilanetriol, aminoethylmethylsilanediol, aminoethyldimethylsilanol, 3-aminopropylsilanetriol, 3-aminopropylmethylsilanediol, 3-aminopropyldimethylsilanol, 3-(N-methylamino)propylsilanetriol, 3-(N-methylamino)propylmethylsilanediol, 3-(N-methylamino)propyldimethylsilanol, 3-(N-dimethylamino)propylsilanetriol, 3-(N-dimethylamino)propylmethylsilanediol, 3-(N-dimethylamino)propyldimethylsilanol, N-(2-aminoethyl)-3-aminopropylsilanetriol, N-(2-aminoethyl)-3-aminopropylmethylsilanediol, N-(2-aminoethyl)-3-aminopropyldimethylsilanol, 3-pyrrolidinylpropylsilanetriol, 3-pyrrolidinylpropylmethylsilanediol, 3-pyrrolidinylpropyldimethylsilanol, 3-piperidinylpropylsilanetriol, 3-piperidinylpropylmethylsilanediol, 3-piperidinylpropyldimethylsilanol, 3-(1-piperazinyl)propylsilanetriol, 3-(1-piperazinyl)propylmethylsilanediol, 3-(1-piperazinyl)propyldimethylsilanol, 3-(4-morpholinyl)propylsilanetriol, 3-(4-morpholinyl)propylmethylsilanediol, and 3-(4-morpholinyl)propyldimethylsilanol. Of these, 3-aminopropylsilanetriol and N-(2-aminoethyl)-3-aminopropylsilanetriol are particularly preferred.

The aminosilanol compound is obtained, for example, by a hydrolysis reaction of an aminoalkylalkoxysilane with water, and an aminosiloxane compound formed by dehydration condensation of the aminosilanol compound is also contained.

The aminosilanol compound and the aminosiloxane compound contained in the aqueous solution containing the aminosilanol compound and the aminosiloxane compound may be derived from one type of aminosilane or a plurality of types of aminosilanes.

The aqueous solution used in the present invention that contains the aminosilanol compound and the aminosiloxane compound may further contain a silanol compound represented by the following general formula (2) and a siloxane compound that is a condensate thereof:

R⁵ₙSi(OH)₄₋ₙ (2)

In the general formula (2), R⁵ is a substituted or unsubstituted monovalent hydrocarbon group having 1 to 20 carbon atoms, preferably 1 to 10 carbon atoms, more preferably 1 to 8 carbon atoms.

The monovalent hydrocarbon group for R⁵ may be linear, branched, or cyclic, and specific examples thereof include those similar to the substituents given as examples for R¹ and R².
n is an integer of 0 to 3, namely, 0, 1, 2, or 3.

Specific examples of silanol compounds represented by the general formula (2) include orthosilicic acid, methylsilanetriol, dimethylsilanediol, trimethylsilanol, ethylsilanetriol, diethyldisilanediol, triethylsilanol, propylsilanetriol, dipropylsilanediol, tripropylsilanol, isopropylsilanetriol, diisopropylsilanediol, triisopropylsilanol, butyl silanetriol, dibutylsilanediol, tributylsilanol, (sec-butyl)silanetriol, di(sec-butyl)silanediol, tri(sec-butyl)silanol, (tert-butyl)silanetriol, di(tert-butyl)silanediol, tri(tert-butyl)silanol, pentylsilanetriol, dipentylsilanediol, tripentylsilanol, hexylsilanetriol, dihexylsilanediol, trihexylsilanol, cyclopentylsilanetriol, dicyclopentylsilanediol, tricyclopentylsilanol, cyclohexylsilanetriol, dicyclohexylsilanediol, and tricyclohexylsilanol. Of these, orthosilicic acid, methylsilanetriol, dimethylsilanediol, trimethylsilanol, ethylsilanetriol, diethyldisilanediol, and triethylsilanol are particularly preferred.

The silanol compound is obtained, for example, by a hydrolysis reaction of an alkylchlorosilane or an alkylalkoxysilane with water, and a siloxane compound formed by dehydration condensation of the silanol compound is also contained.

The silanol compound and the siloxane compound contained in the aqueous solution containing the aminosilanol compound and the aminosiloxane compound may be derived from one type of silane or a plurality of types of silanes. **In** addition, condensates formed by condensation of the aminosilanol compound and the aminosiloxane compound with the silanol compound and the siloxane compound may be contained.

A solvent other than water may be contained in the method for production according to the present invention. Examples of solvents include alcohol solvents such as methanol and ethanol; ether-based solvents such as tetrahydrofuran and dioxane; ester-based solvents such as ethyl acetate and butyl acetate; and aprotic polar solvents such as acetonitrile and N,N-diethylformamide. One or a mixture of two or more of these solvents may be used.

The amount of organic solvent used is 0 wt% or more and less than 50 wt%, preferably 10 to 40 wt%, relative to the entire solvent.

The ion exchange resin is based on polymer molecular chains forming a network structure and contains in the molecule thereof groups that release ions to be exchanged. The ion exchange resin is one generally used in methods for purifying compounds. By contacting the solution of interest with the ion exchange resin, the ions to be removed from the solution are exchanged with the ions adsorbed on the resin in advance, and the ions to be removed can be removed from the solution while being adsorbed on the resin.

Ion exchange resins are broadly classified into acidic cation exchange resins and basic anion exchange resins according to the nature of the ion exchange groups contained therein. Examples of functional groups contained in acidic cation exchange resins include a sulfonic acid group, a carboxylic acid group, a phosphonic acid group, and an aminophosphoric acid group, whereas examples of functional groups contained in basic anion exchange resins include an amino group and a quaternary ammonium group.

Typically, acidic cation exchange resins are used to remove metal impurities. **In** terms of metal impurity removal efficiency, the adsorption action between an ion exchange resin and a substance is in equilibrium; therefore, when metal impurities are removed from, for example, an aqueous amine solution, a higher amine compound concentration results in a higher frequency at which the larger amount of basic amine component present therein is adsorbed onto the surface of an acidic ion exchange resin. Thus, in a situation in which an amine component has already been adsorbed on most of the surface of an ion exchange resin, trace amounts of metal impurities are unlikely to be adsorbed, meaning that the metal impurity removal efficiency is low. Therefore, the use of an acidic ion exchange resin as a method for removing trace amounts of metal components from an aqueous solution of an aminosilanol compound and an aminosiloxane compound is less suitable for higher aqueous solution concentrations.

Furthermore, whereas low-molecular-weight monomers can be easily desorbed from the surface of an ion exchange resin, polymers such as aminosiloxane compounds are not easily desorbed from the surface of an ion exchange resin because aminosiloxane compounds themselves have a complicated structure and contain many amino groups and are therefore adsorbed by acidic functional groups over a wide area at multiple sites per molecule. Thus, it is thought that metal impurities are not easily removed from an aqueous solution containing a polymer such as an aminosiloxane compound.

Accordingly, it is conventionally thought that acidic cation exchange resins are not suitable for purification of basic compounds. Surprisingly, however, it has been found that metal impurities can be reduced when acidic cation exchange resins are used for purification of aminosilanol compounds and aminosiloxane compounds.

Although there is no limitation on the ion exchange groups present in the acidic cation exchange resin used in the present invention, a sulfonic acid group, a carboxylic acid group, a phosphonic acid group, and an aminophosphoric acid group are preferred.

Although there is no limitation on the form of the cation exchange resin, filters (discs), granules, columns, and cartridges are preferred because they are easily available.

Examples of methods for contacting the aqueous solution of the aminosilanol compound and the aminosiloxane compound with the acidic cation exchange resin include a liquid flow method in which the aqueous solution is allowed to flow through the acidic cation exchange resin itself or a column or filter packed therewith and a method in which the acidic cation exchange resin is added to the aqueous solution, followed by an operation such as stirring and then filtration. The liquid flow method is preferred.

Although there is no limitation on the liquid flow rate at which the aqueous solution containing the aminosilanol compound and the aminosiloxane compound is allowed to flow through the acidic cation exchange resin, the liquid flow rate is preferably 1 to 100 ml/min., more preferably 3 to 50 ml/min., even more preferably 5 to 25 ml/min., for a filter with a diameter of 47 mm.

Although there is no limitation on the pressure during liquid flow, atmospheric pressure is preferred because it can be easily implemented.

In the present invention, the concentration of the aminosilanol compound and aminosiloxane compound in the aqueous solution to be contacted with the acidic cation exchange resin is 10 to 70 wt%, preferably 20 to 60 wt%, more preferably 25 to 55 wt%. When the concentration is less than 10 wt%, a large amount of aqueous solution is used because of the low concentration, which is economically inefficient in view of treatment time and treatment area, for example, during liquid flow. On the other hand, when the concentration is more than 70 wt%, it is difficult to perform treatment such as liquid flow itself because of the higher aqueous solution viscosity.

When the aqueous solution contains a silanol compound and a siloxane compound, there is no particular limitation on the concentration of the silanol compound and the siloxane compound; however, the concentration is preferably such that the total concentration of the aminosilanol compound, the aminosiloxane compound, the silanol compound, and the siloxane compound is 10 to 70 wt%, more preferably 20 to 60 wt%, even more preferably 25 to 55 wt%.

A composition for etching according to the present invention contains an aqueous solution of an aminosilanol compound and an aminosiloxane compound with sodium, potassium, and calcium contents respectively of less than 250 ppb, preferably 220 ppb or less, more preferably 200 ppb or less, and an iron content of less than 100 ppb, preferably 80 ppb or less, more preferably 50 ppb or less.

As the aqueous solution of the aminosilanol compound and the aminosiloxane compound with low metal contents, it is preferred to use an aqueous solution which contains an aminosilanol compound represented by the formula (1) and an aminosiloxane compound that is a condensate thereof and whose metal contents are reduced by the method using the acidic cation exchange resin described above.

The composition for etching according to the present invention preferably contains the aqueous solution of the purified aminosilanol compound and aminosiloxane compound with reduced metal contents described above and an acidic substance, such as hydrofluoric acid or phosphoric acid, that is generally used in acidic compositions for etching.

Although there is no limitation on the content of the aqueous solution of the aminosilanol compound and the aminosiloxane compound in the composition for etching according to the present invention, the content is preferably 0.001 to 50 wt%, more preferably 0.005 to 30 wt%, even more preferably 0.01 to 10 wt%, relative to the entire composition for etching to improve the etching selectivity of nitride films to oxide films and to inhibit formation of particles.

As described above, the concentration of the aminosilanol compound and the aminosiloxane compound in the aqueous solution is 10 to 70 wt%, preferably 20 to 60 wt%, more preferably 25 to 55 wt%.

In addition, the aqueous solution of the aminosilanol compound and the aminosiloxane compound used for the etching composition may further contain a silanol compound represented by the general formula (2) and a siloxane compound that is a condensate thereof.

In this case, although there is no particular limitation on the concentration of the silanol compound and the siloxane compound in the aqueous solution, the concentration is preferably such that the total concentration of the aminosilanol compound, the aminosiloxane compound, the silanol compound, and the siloxane compound is 10 to 70 wt%, more preferably 20 to 60 wt%, even more preferably 25 to 55 wt%.

### EXAMPLES

The present invention will be more specifically described below with reference to Examples, although the present invention is not limited to the following Examples.

### [1] Production of Aqueous Solution Containing Aminosilanol Compound and Aminosiloxane Compound

### [Synthesis Example 1]

A 5 L four-necked glass flask was equipped with a fractionating head with a reflux condenser, a thermometer, and a stirring impeller, and the interior thereof was purged with nitrogen. In the flask was placed 3 kg of ion exchange water, and the temperature was adjusted to 20°C to 30°C. To the flask was added dropwise 1 kg of 3-aminopropyltriethoxysilane. Thereafter, ethanol formed by hydrolysis and excess water were distilled off to obtain an aqueous solution containing an aminosiloxane compound in which the concentration of 3-aminopropylsilanetriol and a condensate thereof was 33.6 wt% and which had a viscosity of 9.5 mm²/s, a specific gravity of 1.109, and an amine equivalent of 345 g/mol.

### [Synthesis Example 2]

A 5 L four-necked glass flask was equipped with a fractionating head with a reflux condenser, a thermometer, and a stirring impeller, and the interior thereof was purged with nitrogen. In the flask was placed 3 kg of ion exchange water, and the temperature was adjusted to 20°C to 30°C. To the flask was added dropwise 1 kg of 3-aminopropyltriethoxysilane. Thereafter, ethanol formed by hydrolysis and excess water were distilled off to obtain an aqueous solution containing an aminosiloxane compound in which the concentration of 3-aminopropylsilanetriol and a condensate thereof was 44.4 wt% and which had a viscosity of 52.9 mm²/s, a specific gravity of 1.154, and an amine equivalent of 261 g/mol.

### [Synthesis Example 3]

A 5 L four-necked glass flask was equipped with a fractionating head with a reflux condenser, a thermometer, and a stirring impeller, and the interior thereof was purged with nitrogen. In the flask was placed 1.5 kg of ion exchange water, and the temperature was adjusted to 20°C to 30°C. To the flask were added dropwise 0.3 kg of N-2-(aminoethyl)-3-aminopropyltrimethoxysilane and 0.1 kg of tetraethoxysilane. Thereafter, alcohol formed by hydrolysis and excess water were distilled off to obtain an aqueous solution containing an aminosiloxane compound in which the concentration of a composition composed of N-2-(aminoethyl)-3-aminopropylsilanetriol and a condensate thereof, orthosilicic acid and a condensate thereof, and a condensate of N-2-(aminoethyl)-3-aminopropylsilanetriol with orthosilicic acid was 30.2 wt% and which had a viscosity of 9.2 mm²/s, a specific gravity of 1.100, and an amine equivalent of 254 g/mol.

### [2] Production of Aqueous Solution of Purified Aminosilanol Compound and Aminosiloxane Compound

### [Example 1-1]

Two 250 mL polypropylene (hereinafter also referred to as "PP") bottles were provided, and 150 g of the aqueous solution obtained in Synthesis Example 1 was placed in one of the bottles. An acidic cation exchange resin (SCP, manufactured by 3M Japan Limited, diameter: 47 mm, disc type) through which the aqueous solution was to be allowed to flow was attached to a polytetrafluoroethylene (hereinafter also referred to as "PTFE") filter holder. The aqueous solution was allowed to flow through the acidic cation exchange resin using a Smoothflow Pump (manufactured by Tacmina Corporation) and a PTFE tube at a liquid flow rate of 15 g/min. and was collected in the other 250 mL PP bottle on the receiver side. After collection, the PP bottle on the receiver side and the empty PP bottle on the liquid flow side were exchanged, and the aqueous solution collected in the PP bottle on the receiver side was allowed to flow through the acidic cation exchange resin again using the pump. This liquid flow operation was repeated ten times to collect an aqueous solution containing purified 3-aminopropylsilanetriol and aminosiloxane compound that was a condensate thereof.

Thereafter, the contents of main metal impurities contained in 142.3 g of the collected aqueous solution were measured using an inductively coupled plasma mass spectrometer (Agilent 7700× ICP-MS, manufactured by Agilent Technologies, Inc.). The results are shown in Table 1.

**[Table 1]**

| Metal impurity (unit: ppb) | Before liquid flow | After liquid flow |
|---|---|---|
| Li | 21 | ≤10 |
| Na | 189 | ≤10 |
| Mg | 28 | ≤10 |
| Al | 69 | 23 |
| K | 109 | 88 |
| Ca | 291 | 21 |
| Fe | 12 | ≤10 |
| Zn | 16 | ≤10 |

As shown in Table 1, the metal impurities contained in the aqueous solution obtained in Synthesis Example 1 were found to be reduced after the aqueous solution was allowed to flow through the acidic cation exchange resin. In particular, the contents of Na, which is said to tend to have a bad influence to withstand voltage of an oxide film, and Ca, which can degrade the dielectric withstand characteristics of gate oxide films, were significantly reduced after filtration.

The detection limit of the metal impurity contents is 10 ppb. The Cr, Mn, Ni, Co, Cu, Ag, In, Ta, and Pb contents measured at the same time were all at or below the detection limit, that is, 10 ppb or less, before liquid flow through the acidic cation exchange resin; therefore, they were not measured after liquid flow.

### [Example 1-2]

Two 250 mL PP bottles were provided, and 150 g of the aqueous solution obtained in Synthesis Example 2 was placed in one of the bottles. An aqueous solution containing purified 3-aminopropylsilanetriol and aminosiloxane compound that was a condensate thereof was collected by the same operation as in Example 1-1 except that the liquid flow rate was 10 g/min. since the viscosity was higher than that in Synthesis Example 1.

Thereafter, the contents of main metal impurities contained in 147.0 g of the collected aqueous solution were measured as in Example 1-1. The results are shown in Table 2.

**[Table 2]**

| Metal impurity (unit: ppb) | Before liquid flow | After liquid flow |
|---|---|---|
| Li | 13 | ≤10 |
| Na | 198 | ≤10 |
| Mg | 45 | 12 |
| Al | 48 | 40 |
| K | 130 | ≤10 |
| Ca | 370 | 28 |
| Fe | 46 | 34 |
| Zn | 22 | 21 |

As shown in Table 2, as in Example 1-1, the metal impurities contained in the aqueous solution obtained in Synthesis Example 2 were found to be reduced after the aqueous solution was allowed to flow through the acidic cation exchange resin, even when an aminosilanol compound and an aminosiloxane compound that was a condensate thereof with high viscosity were used. In addition, since the treatment rate was reduced because of the effect of viscosity, the aqueous solution was contacted with the ion exchange resin for a longer period of time, and the content of K, which tends to have a bad influence to withstand voltage of an oxide film, was also significantly reduced after filtration.

The detection limit of the metal impurity contents is 10 ppb. The Cr, Mn, Ni, Co, Cu, Ag, In, Ta, and Pb contents measured at the same time were all at or below the detection limit, that is, 10 ppb or less, before liquid flow through the acidic cation exchange resin; therefore, they were not measured after liquid flow.

### [Example 1-3]

Two 250 mL PP bottles were provided, and an aqueous solution containing a purified composition composed of N-2-(aminoethyl)-3-aminopropylsilanetriol and a condensate thereof, orthosilicic acid and a condensate thereof, and a condensate of N-2-(aminoethyl)-3-aminopropylsilanetriol with orthosilicic acid was collected by the same operation as in Example 1-1 except that 150 g of the aqueous solution obtained in Synthesis Example 3 was placed in one of the bottles.

Thereafter, the contents of main metal impurities contained in 147.5 g of the collected aqueous solution were measured as in Example 1-1. The results are shown in Table 3.

**[Table 3]**

| Metal impurity (unit: ppb) | Before liquid flow | After liquid flow |
|---|---|---|
| Li | ≤10 | ≤10 |
| Na | 325 | 126 |
| Mg | 33 | 17 |
| Al | 23 | 20 |
| K | 133 | 118 |
| Ca | 90 | 32 |
| Fe | 24 | 23 |
| Zn | 139 | 137 |

As shown in Table 3, the metal impurities contained in the aqueous solution obtained in Synthesis Example 3 were found to be reduced after the aqueous solution was allowed to flow through the acidic cation exchange resin, even though the composition composed of N-2-(aminoethyl)-3-aminopropylsilanetriol and the condensate thereof, orthosilicic acid and the condensate thereof, and the condensate of N-2-(aminoethyl)-3-aminopropylsilanetriol with orthosilicic acid in Synthesis Example 3 had two nitrogen atoms in one aminosilane molecule and was accordingly easily adsorbable onto the acidic cation exchange resin.

The detection limit of the metal impurity contents is 10 ppb. The Cr, Mn, Ni, Co, Cu, Ag, In, Ta, and Pb contents measured at the same time were all at or below the detection limit, that is, 10 ppb or less, before liquid flow through the acidic cation exchange resin; therefore, they were not measured after liquid flow.

### [3] Preparation of Composition for Etching and Etching Treatment

### [Example 2-1]

A nitride film on a silicon wafer substrate having an oxide film and the nitride film formed thereon was subjected to etching treatment at 155°C using a composition for etching containing 3.0 wt% of the aqueous solution obtained in Example 1-1 (1.0 wt% of 3-aminopropylsilanetriol and an aminosiloxane compound component that was a condensate thereof) and 97.0 wt% of an 85 wt% phosphoric acid aqueous solution.

As in the case of the aqueous solution obtained in Example 1-1, the amounts of metal impurities on the surface of the silicon wafer substrate after cleaning were smaller than those in the composition for etching without liquid flow through the acidic cation exchange resin.

## Claims

1. A method for producing an aqueous solution of a purified aminosilanol compound and aminosiloxane compound, the method comprising contacting, with an acidic cation exchange resin, an aqueous solution containing an aminosilanol compound and an aminosiloxane compound that is a condensate thereof to remove a metal component from the aqueous solution, the aminosilanol compound being represented by the following general formula (1):
R¹R²N-R³-SiR⁴ₘ(OH)₃₋ₘ (1)
wherein R¹ and R² each independently represent a hydrogen atom or a substituted or unsubstituted monovalent hydrocarbon group having 1 to 20 carbon atoms that may contain a heteroatom, R¹ and R² may be bonded together to form a ring with a nitrogen atom to which R¹ and R² are bonded, R³ represents a substituted or unsubstituted divalent hydrocarbon group having 1 to 20 carbon atoms that may contain a heteroatom, R⁴ represents a substituted or unsubstituted monovalent hydrocarbon group having 1 to 20 carbon atoms, and m represents an integer of 0 to 2,
wherein a concentration of the aminosilanol compound and the aminosiloxane compound in the aqueous solution to be contacted with the acidic cation exchange resin is 10 to 70 wt%.

2. The method for producing an aqueous solution of a purified aminosilanol compound and aminosiloxane compound according to claim 1, wherein the aqueous solution to be contacted with the acidic cation exchange resin further contains a silanol compound represented by the following general formula (2) and a siloxane compound that is a condensate thereof:
R⁵ₙSi(OH)₄₋ₙ (2)
wherein R⁵ represents a substituted or unsubstituted monovalent hydrocarbon group having 1 to 20 carbon atoms, and n represents an integer of 0 to 3.

3. A composition for etching comprising an aqueous solution of an aminosilanol compound and an aminosiloxane compound, the composition for etching having sodium, potassium, and calcium contents respectively of less than 250 ppb and an iron content of less than 100 ppb.

4. The composition for etching according to claim 3, wherein the aminosilanol compound and the aminosiloxane compound are an aminosilanol compound represented by the following general formula (1) and an aminosiloxane compound that is a condensate thereof:
R¹R²N-R³-SiR⁴ₘ(OH)₃₋ₘ (1)
wherein R¹ and R² each independently represent a hydrogen atom or a substituted or unsubstituted monovalent hydrocarbon group having 1 to 20 carbon atoms that may contain a heteroatom, R¹ and R² may be bonded together to form a ring with a nitrogen atom to which R¹ and R² are bonded, R³ represents a substituted or unsubstituted divalent hydrocarbon group having 1 to 20 carbon atoms that may contain a heteroatom, R⁴ represents a substituted or unsubstituted monovalent hydrocarbon group having 1 to 20 carbon atoms, and m represents an integer of 0 to 2.

5. The composition for etching according to claim 3 or 4, wherein the aqueous solution further contains a silanol compound represented by the following general formula (2) and a siloxane compound that is a condensate thereof:
R⁵ₙSi(OH)₄₋ₙ (2)
wherein R⁵ represents a substituted or unsubstituted monovalent hydrocarbon group having 1 to 20 carbon atoms, and n represents an integer of 0 to 3.
